(19) Europäisches Patentamt
European Patent Office
Office européen des brevets

(11) **EP 0 708 509 B1**

(12) # FASCICULE DE BREVET EUROPEEN

(45) Date de publication et mention
de la délivrance du brevet:
**26.08.1998 Bulletin 1998/35**

(51) Int Cl.⁶: **H01S 3/00**, G02B 5/32, G02B 27/00

(21) Numéro de dépôt: **95402314.9**

(22) Date de dépôt: **17.10.1995**

(54) **Dispositif d'émission mono-longueur d'onde**

Vorrichtung zur Emission von Strahlung einer einzelnen Wellenlänge

Single wavelength emitting device

(84) Etats contractants désignés:
**DE GB**

(30) Priorité: **19.10.1994 FR 9412487**

(43) Date de publication de la demande:
**24.04.1996 Bulletin 1996/17**

(73) Titulaire: **THOMSON-CSF**
**75008 Paris (FR)**

(72) Inventeurs:
• **Nicolas, Christophe**
**F-92402 Courbevoie Cedex (FR)**
• **Huignard, Jean-Pierre**
**F-92402 Courbevoie Cedex (FR)**
• **Naudan, Frédéric**
**F-92402 Courbevoie Cedex (FR)**

(56) Documents cités:
**US-A- 4 703 992**    **US-A- 4 776 652**
**US-A- 4 878 718**

• **ICIASF'89 INTERNATIONAL CONGRESS ON INSTRUMENTATION AND AEROSPACE SIMULATION FACILITIES, RESEARCH CENTER GÖTTINGEN W. GERMANY , SEPTEMBER 18-21 1989, pages 595-601, XP 000078170 H.D. TOLL ET AL 'Design and febrication of an integrated holographic laser doppler optics'**
• **JETP - LETTERS, vol. 14, no. 1, 1971 NEW YORK US, pages 17-20, M.S. SOSKIN ET AL 'Holographic method of amplitude -phase correction of laser beams'**
• **AT & T BELL LABORATORIES TECHNICAL JOURNAL, vol. 48, no. 9, Novembre 1969 NEW YORK US, pages 2909-2947, H. KOGELNIK 'Coupled wave theory for thick hologram gratings'**
• **OPTICS LETTERS., vol. 10, no. 4, Avril 1971 NEW YORK US, pages 896-900, J.E. WARD ET AL 'Lens abberation correction by holography'**
• **PATENT ABSTRACTS OF JAPAN vol. 7 no. 166 (E-188) ,21 Juillet 1985 & JP-A-58 071686 (RICOH KK)**

## Description

L'invention concerne un dispositif d'émission mono-longueur d'onde et plus particulièrement un dispositif émettant un faisceau mono-longueur d'onde cohérent dont le diagramme de rayonnement présente une bande passante angulaire étroite, par exemple égale voire inférieure à 0,3°.

Un laser à semi-conducteur produit un rayonnement dont les cohérences spatiale et temporelle ainsi que la puissance dépendent de la géométrie de la cavité résonante.

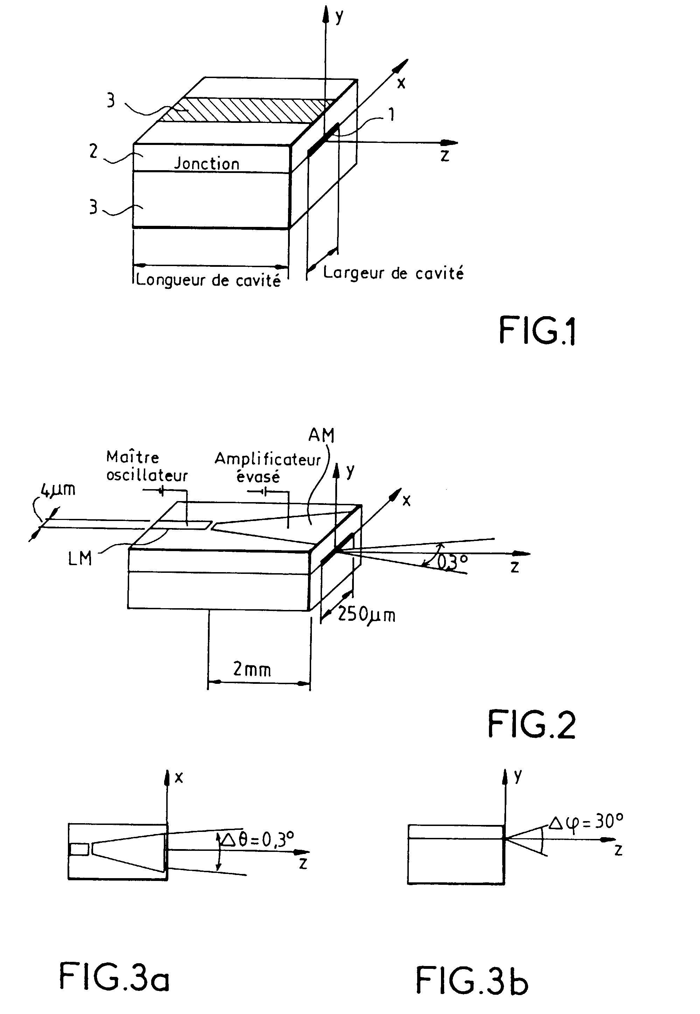

Sur la figure 1, représentant un tel laser, on distingue la direction transverse y, perpendiculaire au plan xz de la jonction laser et la direction latérale x, parallèle à la jonction laser (voir figure 1). La direction moyenne d'émission lumineuse z est aussi parallèle au plan de la jonction laser.

Dans la direction transverse y, la cavité est délimitée par l'épaisseur de la zone active 1 qui est très faible, inférieure au micromètre. Le confinement de l'onde est assuré par la forte différence entre les indices de réfraction de la couche active 1 et des couches de confinement 2 et 3. On dit qu'il y a "guidage par l'indice". En général, dans le plan yz, seul un mode d'oscillation est autorisé par ce guidage transverse. On dit que le laser est monomode transverse.

Dans la direction latérale x, la cavité est délimitée soit par un guidage par l'indice, soit par un guidage par le gain. Dans ce dernier cas, c'est le flux du courant électrique d'injection à travers la couche active (par l'électrode 3) qui délimite latéralement la zone à gain laser. Pour une longueur de cavité donnée, plus la largeur de la cavité est grande, plus le laser est puissant, et moins il est cohérent. En effet, plus la cavité est large, plus les modes latéraux d'oscillation sont nombreux. Le laser devient multimode latéral.

Le caractère multimode latéral se traduit par un diagramme de rayonnement complexe (multilobe) par une étendue géométrique relativement élevée, et par un spectre d'émission à fréquences multiples. Afin de disposer d'un maximum de puissance optique dans un angle solide le plus faible possible, avec des composants semi-conducteurs, trois techniques sont mises en oeuvre, qui permettent de conserver la compacité de la source :

i)   Additionner de façon cohérente les flux lumineux de plusieurs lasers monomodes. Pour cela, on fabrique un réseau de lasers intégrés en un composant monolithique avec couplage contrôlé des lasers entre eux.

ii)  Forcer l'oscillation d'un laser à cavité large sur un mode latéral unique: en remplaçant l'électrode laser par un réseau d'électrodes fines et/ou en injectant dans la cavité large le faisceau d'un laser monomode de faible puissance.

iii) Amplifier le rayonnement d'un laser monomode à l'aide d'un composant semi-conducteur conçu pour conserver la qualité modale du faisceau .

L'invention qui va être décrite s'applique à ces différents types de source "à cohérence élevée" et plus particulièrement à la troisième catégorie, à titre d'exemple significatif.

Cette dernière solution semble la plus prometteuse, il s'agit de la structure "MOPA" (Maître Oscillateur-Amplificateur de Puissance) telle que décrite par exemple dans l'article "Operating characteristics of a High-Power Monolithically Integrated Flared Amplifier Master Oscillator Power Amplifier" de Stephen O'BRIEN et al, IEEE Journal of Quantum Electronics, vol. 29, n°6, June 1993.

Dans sa version la plus élaborée (voir figure 2), sur un même composant sont intégrés un laser monomode LM et un amplificateur AM de forme évasée.

Le laser monomode LM et l'amplificateur AM partagent la même jonction. Le couplage entre le laser et l'amplificateur est optimisé. La zone active de l'amplificateur est délimitée latéralement par la forme évasée de son électrode. Cette forme permet l'amplification de l'onde laser tout en conservant sa bonne qualité modale.

Les sources cohérentes obtenues par les trois techniques citées ci-dessus sont caractérisées par un diagramme de rayonnement relativement étroit. Leur étendue géométrique est proche de la valeur $E_o = \lambda^2$, où $\lambda$ est la longueur d'onde du rayonnement.

Par exemple, pour un MOPA à la longueur d'onde $\lambda$ = 975 nm, et pour une largeur de zone émissive L = 250 $\mu$m, le diagramme angulaire de rayonnement latérale, dans le plan xz est constitué idéalement d'un lobe de largeur à mi-hauteur (voir figure 3a) = $\Delta\theta$ = 0,3°

Dans le plan yz, pour une hauteur de zone émissive inférieure au micromètre, le diagramme de rayonnement transverse est beaucoup plus ouvert (voir figure 3b) = $\Delta\varphi \approx 30°$.

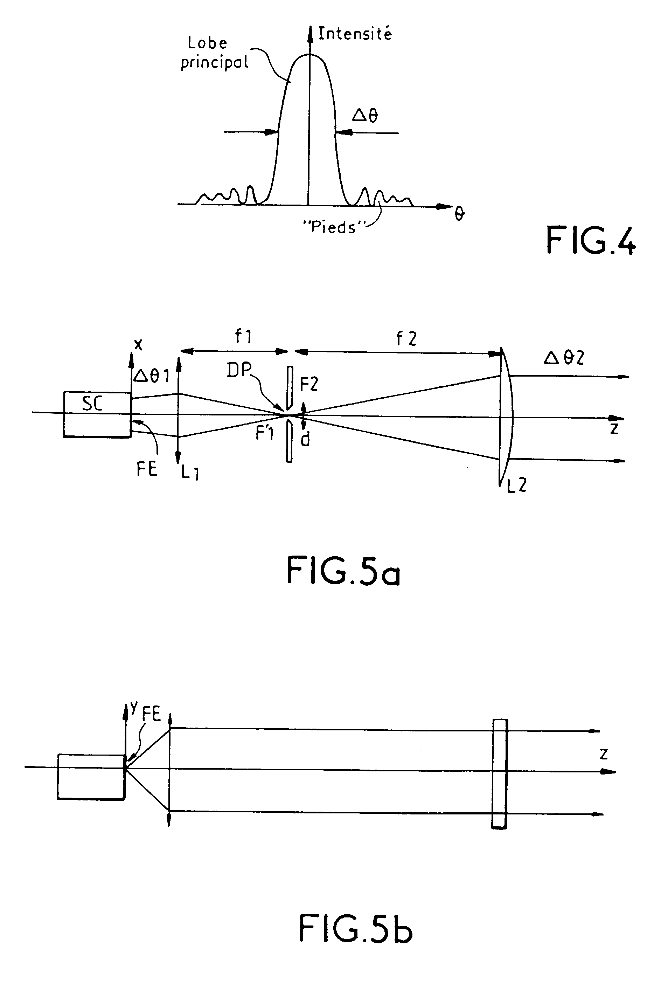

Les imperfections des sources cohérentes, conduisent à une dégradation du diagramme de rayonnement latéral qui se traduit, par exemple, par l'apparition de "pieds" (ou émissions secondaires) de part et d'autre du lobe principal de rayonnement (figure 4).

De plus, une modification des conditions de fonctionnement peut conduire à une modification néfaste du diagramme de rayonnement : élargissement du lobe principal, augmentation de l'importance du rayonnement hors bande passante $\Delta\theta$.

Une technique classique employée afin de conserver un diagramme de rayonnement étroit et, par conséquent, une bonne cohérence spatiale, consiste à adjoindre à la source cohérente un système optique de filtrage spatial constitué de lentilles et d'un diaphragme à fente tel que représenté en figures 5a et 5b. La fente DP est orientée selon une direction perpendiculaire au plan de la jonction du laser SC.

Selon la figure 5a qui représente le système selon une vue perpendiculaire (plan xz) à la direction de la fente DP, le faisceau issu de la source cohérente SC est légèrement divergent (par exemple $\Delta\theta_1 = 0,3°$, plus les "pieds" du diagramme). Une lentille $L_1$ forme en son foyer image $F_1'$, une tache de dimension $d = f_1.\Delta\theta$.

Une fente de filtrage, d'ouverture égale à d est disposée en $F_1'$. Elle ne laisse passer que le flux lumineux correspondant au lobe principal. Une lentille convergente cylindrique $L_2$ dont le foyer objet $F_2$ coïncide avec $F_1'$ permet de collimater les rayons qui sont passés par l'ouverture de la fente. Ainsi le diagramme de rayonnement global est limité à sa partie utile comprise dans la bande passante angulaire (le lobe principal) :

$$\Delta\theta_2 = \frac{d}{f_2}$$

La relation de grandissement angulaire est :

$$\frac{\Delta\theta_2}{\Delta\theta_1} = \frac{f_1}{f_2}$$

La figure 5b représente le système selon une vue parallèle (plan yz) à la fente DP. Sur cette figure, la même lentille $L_1$ collimate directement les rayons (dans le plan yz) pourvu que son foyer objet corresponde avec la zone émissive de SC. Comme la source est généralement monomode dans le plan yz, aucun système de filtrage spatial n'est nécessaire. C'est pourquoi, la lentille $L_2$ est cylindrique.

Comme on le voit aisément, le système de filtrage spatial accroît considérablement la complexité globale de la source. On doit, en effet, considérer que la source cohérente est constituée du sous-ensemble émissif à semi-conducteur et du système optique de filtrage.

Pour que l'ouverture de la fente de filtrage soit de dimension raisonnable d'un point de vue mécanique, les distances focales $f_1$ et $f_2$ doivent être relativement importantes.

A titre d'exemple, un tel système peut être réalisé avec les valeurs numériques suivantes :
$f_1 = 6$ mm          $d = 30$ $\mu$m

La seconde lentille, $L_2$, doit être de focale relativement importante afin de permettre d'insérer la fente, ce qui implique un accroissement de l'encombrement général. Ainsi, on trouve des ensembles MOPA + filtre dont la longueur hors-tout est de l'ordre de 20 cm.

Si l'on voulait utiliser une microlentille pour $L_1$, la fente devrait être de très faible ouverture : $f_1 = 500$ $\mu$m ===> $d = 3$ $\mu$m.

Cela pose certainement de nombreux problèmes mécaniques au niveau du positionnement.

Chaque fente de filtrage doit être ajustée avec précision en fonction du MOPA utilisé. De plus, toute modification de la direction moyenne d'émission de la source à semi-conducteur rend la fente inopérante.

Le flux lumineux qui n'est pas transmis par la fente est définitivement perdu. Il peut même retourner vers la source SC par réflexion, et ainsi, perturber son fonctionnement.

L'invention qui va maintenant être décrite dispense de l'utilisation d'une fente de filtrage et permet de réduire considérablement l'encombrement global de la source.

La structure MOPA est la source laser à semiconducteur la plus puissante ayant une cohérence maximale. Le Le flux énergétique disponible est typiquement de 1 Watt à la longueur d'onde $\lambda = 975$ nm. Le diagramme de rayonnement est limité par la diffraction car sa largeur à mi-hauteur est de $\Delta\theta = 0,3°$ dans la direction parallèle à la jonction pour une ouverture de 250 $\mu$m.

Un tel laser associé à un système de filtrage comme représenté en figures 5a, 5b devrait fournir un faisceau de bonne qualité. Cependant, le filtrage spatial n'est efficace que pour un point de fonctionnement déterminé du laser.

Malheureusement, en s'échauffant, le laser est le siège de phénomènes de gradient thermique et de saturation non-uniforme du gain dans l'amplificateur qui induisent une courbure du front de phase, voire à une courbure irrégulière. Comme on vient de le voir, la fente de filtrage spatiale peut être réglée (dimensions et positions) pour un point de fonctionnement donné. Dès que la puissance du laser change, le système n'est plus convenablement filtré. L'énergie lumineuse n'est plus centrée sur la fente et le flux global du faisceau "filtré" diminue.

L'invention permet de pallier cet inconvénient.

L'invention concerne donc un dispositif optique d'émission mono-longueur d'onde comprenant une source optique émettant un faisceau lumineux mono-longueur d'onde caractérisé en ce qu'il comporte un dispositif holographique dans lequel a été enregistré un réseau d'indice par interférence de deux ondes lumineuses planes toutes deux mono-longueur d'onde à une même valeur déterminée et dirigées selon deux directions, concourantes dans le dispositif holographique. Le dispositif holographique est éclairé par ledit faisceau lumineux.

L'invention concerne également un dispositif, caractérisé en ce que le dispositif holographique transmet selon une première direction une première onde plane dont le diagramme de rayonnement est compris dans une bande angulaire déterminée ($\Delta\theta$) et, selon une deuxième direction, une deuxième onde ou plusieurs dont le diagramme de rayonnement est situé en-dehors de cette bande angulaire. Ce dispositif comporte également un dispositif de réflexion permettant de rendre concourantes la première et la deuxième onde, ainsi qu'un dispositif de transfert d'énergie situé dans la zone d'interférence des deux ondes. Ce dispositif transférant l'énergie de la seconde onde dans la direction de la première onde sans que le diagramme de rayonnement de cette première onde en soit modifié.

Les différents objets et caractéristiques de l'invention apparaîtront plus clairement dans la description qui va suivre et dans les figures annexées qui représentent :

- les figures 1 à 4, des sources laser à semi-conducteurs de l'état de la technique et décrits précédemment ;
- les figures 5a et 5b, un système de filtrage angulaire pour améliorer le diagramme de rayonnement d'un laser ;
- les figures 6a et 6b, un exemple de réalisation du système de l'invention ;
- les figures 7, 8a, 8b et 9, un exemple de réalisation du dispositif holographique utilisé dans le système des figures 6a et 6b ;
- les figures 10a et 10b, un exemple de réalisation de la lentille de collimation du système des figures 6a et 6b ;
- la figure 11, un exemple d'assemblage des éléments du système de l'invention ;
- la figure 12, une autre forme de réalisation de l'invention dans laquelle la lentille L1 est un hologramme de surface ;
- la figure 13, une variante de réalisation de l'invention permettant d'améliorer le rendement énergétique du système ;
- la figure 14, une variante de réalisation de la source laser SC ;
- la figure 15, une variante de réalisation permettant un réglage de l'efficacité de diffraction du système.

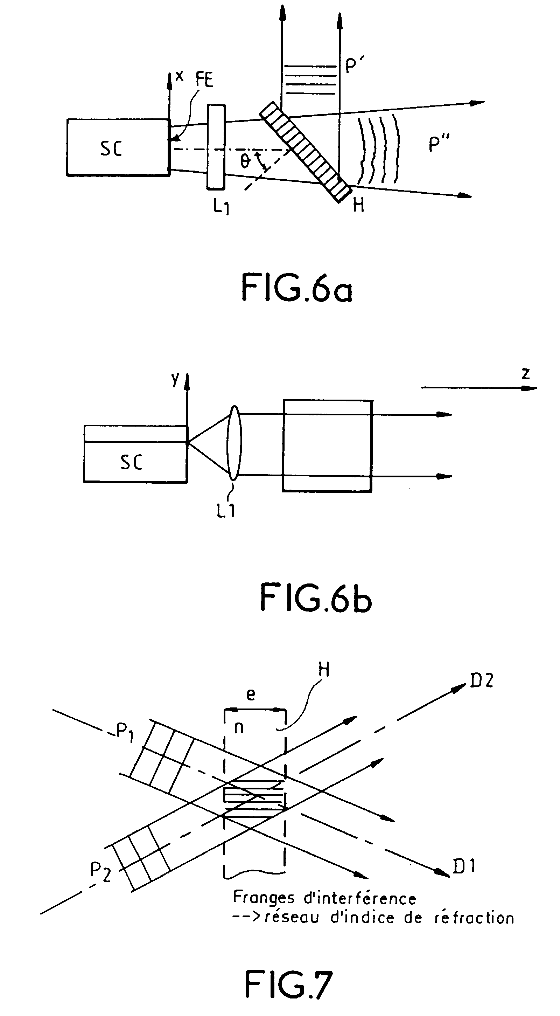

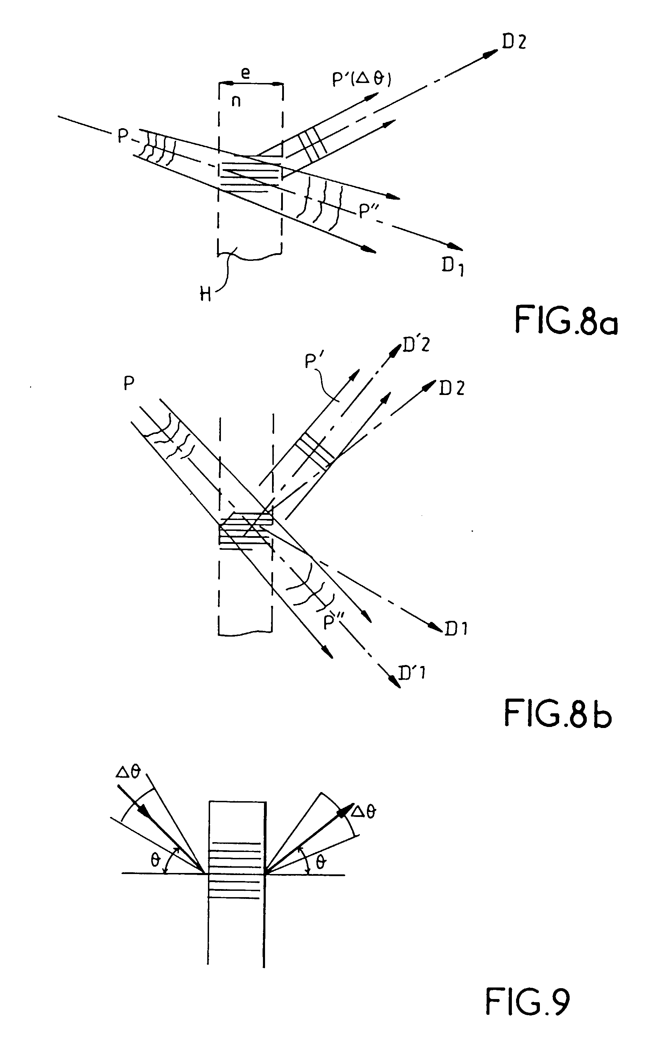

En se reportant aux figures 6a et 6b, puis les figures 7 et 8, on va décrire tout d'abord un exemple de réalisation générale du système de l'invention.

Comme représentés en figure 6a et 6b, on associe à une source monochromatique SC un dispositif holographique H. Le positionnement et la fonction de ce dispositif holographique H seront décrits ultérieurement. On va tout d'abord décrire son mode de réalisation.

Le dispositif holographique est réalisé de la façon suivante : un milieu photosensible H est soumis à deux ondes planes P1, P2 de même longueur d'onde (voir figure 7) se croisant dans le milieu photosensible qui est transparent à cette longueur d'onde. Dans la zone de recouvrement des deux ondes, celles-ci interfèrent et créent un réseau de franges d'interférence dont la direction est bissectrice des directions des ondes planes.

Le milieu optique est un matériau photosensible, dont l'indice de réfraction est affecté par l'intensité lumineuse, il se crée une modulation de l'indice de réfraction, d'amplitude dn, en correspondance avec la modulation d'intensité lumineuse résultant des franges d'interférences. Supposons que cette modulation d'indice puisse être inscrite de façon permanente, un hologramme a été inscrit dans le volume du milieu n (d'épaisseur e).

Selon la figure 8a, on éclaire ensuite l'hologramme ainsi enregistré par une onde P presque identique à l'onde $P_1$, mais au front d'onde dégradé et selon la même direction que l'onde $P_1$. La diffraction de l'onde P sur l'hologramme crée une onde P' de même géométrie que l'onde précédente $P_2$ qui avait servi à l'enregistrement. L'onde P' est donc une onde plane ayant le même diagramme de rayonnement que l'onde $P_2$.

L'hologramme est en effet caractérisé par une bande passante angulaire $\Delta\theta$ suivant la loi de diffraction de Bragg. L'efficacité de la diffraction dans la bande passante $\Delta\theta$ peut être proche de 100 % sous certaines conditions géométriques et pour certaines valeurs de dn.

Le complément d'énergie correspondant à la partie dégradée du front d'onde de P est transmis sans diffraction par l'hologramme (onde P''). Il s'agit de la partie de l'onde P qui est hors bande passante $\Delta\theta$.

On a ainsi réalisé une fonction de filtrage angulaire dans la bande passante $\Delta\theta$, du diagramme de P. L'adjonction de ce filtre angulaire holographique à une source émettrice quasi cohérente à semi-conducteur comme cela est fait dans le système des figures 6a et 6b permet de constituer une source optique au diagramme de rayonnement limité par $\Delta\theta$.

Les calculs suivant la théorie des ondes couplées ("Coupled Wave theory for thick hologram gratings" de H. KOGELNIK The Bell System Technical Journal Vol. 48, N°9, pp 2909-2947, November 1979) montrent qu'il est possible d'obtenir une bonne efficacité de diffraction pouvant atteindre 0,95 dans une bande passante $\Delta\theta = 0,3°$ dans la configuration représentée en figure 9 avec, par exemple les valeurs suivantes :

$\theta = 45°$
$n = 1,5$
$dn = 0,003$
$e = 100\ \mu m$
$\lambda = 975\ nm$
$\Lambda$ l'interfrange : $0,46\ \mu m$

Dans le système des figures 6a et 6b, le dispositif holographique H qui se présente sous forme d'une couche plane d'un matériau photosensible est orienté perpendiculairement au plan, de la jonction du laser à semi-conducteur SC et fait un angle déterminé avec le plan contenant la face émissive FE de la jonction. Comme cela est représenté à la figure 6a, la normale au plan du dispositif holographique H fait un angle $\theta$ avec la direction moyenne d'émission du faisceau émis par le laser SC.

La figure 6b représente une vue de dessus du système de la figure 6a.

Dans ce système, comme il n'y a plus de fente de filtrage comme dans le système des figures 5a, 5b, la lentille de collimation L1 peut être cylindrique. Elle est convergente pour le plan transverse seulement (yz) et de très courte focale. En particulier, il est connu de disposer une microlentille cylindrique à très faible distance (quelques centaines de micromètres) de la surface émissive de SC.

Le dispositif holographique peut être réalisé, par exemple, avec l'un des matériaux suivants :

- gélatine dichromatée
- photopolymère
- cristal photosensible (LiNbO$_3$).

L'enregistrement du dispositif holographique selon la figure 7 peut être réalisé à l'aide de faisceaux P1, P2 fournis soit par un laser monomode de faible puissance, soit par une source laser du type MOPA à une température de fonctionnement parfaitement identifiée et que l'on sait donc filtrer selon le système des figures 5a, 5b. Les deux faisceaux P1, P2 peuvent être fournis par une même source, un système de renvoi à l'aide de miroir peut être aisément réalisé pour les faire interférer selon un angle déterminé dans le milieu photosensible.

Comme on l'a vu précédemment, l'enregistrement de l'hologramme dans le dispositif H est fait à l'aide de deux ondes de même longueur d'onde (voir figure 7). Par contre, la lecture de l'hologramme peut être faite avec un faisceau d'une autre longueur d'onde. En figure 8, le faisceau P peut avoir une longueur d'onde différente de celle de P1 et P2. Dans ce cas la direction du faisceau P est différente de celle de l'onde P1. Comme représenté en figure 8b, les faisceaux P et P" sont dirigés selon une direction D'1 différente de D1. Le faisceau diffracté P' a donc également une direction D'2 différente de la direction D2 de la figure 7. Pour obtenir une efficacité de diffraction maximale du faisceau P dans la direction D'2, il convient de régler la direction d'incidence D'1 du faisceau P sur le dispositif holographique.

La figure 15 prévoit de fixer le dispositif holographique H sur une platine orientable P0 permettant de faire varier l'angle d'incidence θ pour obtenir un réglage optimal de l'efficacité de diffraction du faisceau P.

De préférence, l'hologramme est enregistré à une longueur d'onde visible dans du photopolymère.

Egalement de préférence, le dispositif holographique H est un hologramme épais pour être sélectif en longueurs d'ondes. Son épaisseur (100 μm par exemple) est choisie de façon qu'il y ait recouvrement des faisceaux d'enregistrement dans toute son épaisseur.

Selon une variante de réalisation, la lentille de collimation L$_1$ peut être réalisée sous forme d'une lentille holographique.

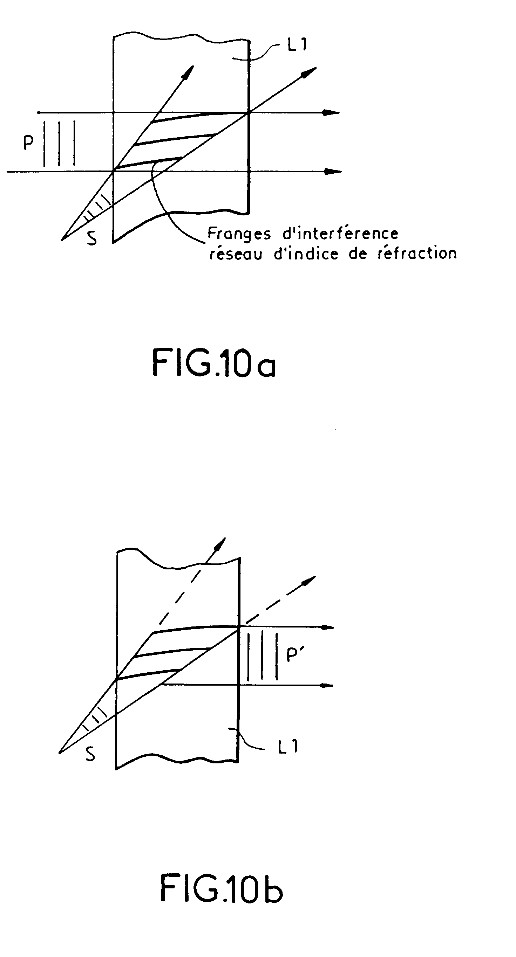

Il est connu de fabriquer des lentilles holographiques, en particulier des lentilles cylindriques. La lentille L$_1$ peut être aussi constituée d'un hologramme épais. Le principe d'une telle lentille est décrit sur la figure 10a.

A l'enregistrement on fait interférer une onde plane P avec une onde cylindrique ou sphérique S. Les franges d'interférences obtenues sont paraboloïdales. A la restitution, l'hologramme est illuminé par l'onde S, et l'onde P' est obtenue par diffraction : cette onde P' est identique à l'onde plane P (figure 10b).

Les deux composants holographiques, lentille L$_1$ et dispositif holographique H peuvent être accolés.

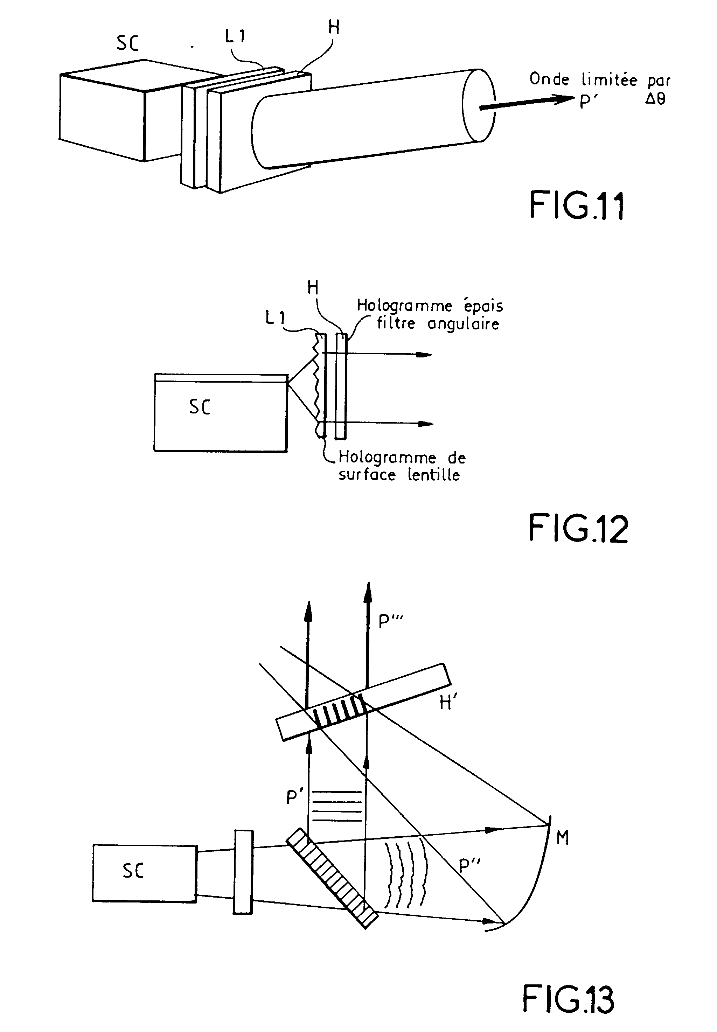

Les deux fonctions peuvent aussi être enregistrées en un même composant. Le même hologramme épais peut exécuter les deux fonctions : filtre angulaire latéral et lentille convergente transverse. Par exemple en faisant interférer une onde équivalente au faisceau idéal qui serait issu d'un MOPA, avec l'onde que l'on souhaite obtenir après collimation et filtrage comme cela est représenté en figure 11. Ces ondes peuvent être obtenues à l'aide d'un laser monomode annexe (pas forcément à semi-conducteur) muni d'un système optique qui permet de simuler un faisceau idéal de MOPA.

Il est connu de fabriquer des lentilles suivant la technique des hologrammes de surface ou hologramme de reliefs. Dans ce cas, une modulation de l'épaisseur du milieu photosensible H est enregistrée. L'hologramme de surface L$_1$ peut être associé à l'hologramme de volume H qui sert de filtre angulaire (figure 12).

La figure 13 représente une variante de réalisation de l'invention dans laquelle on récupère l'énergie lumineuse du faisceau P" du système des figures 6a et 6b. En effet, en figures 6a et 6b, le faisceau lumineux P" est perdu.

Le faisceau P' est l'onde utile, limitée dans la bande angulaire Δθ. L'onde P", correspondant au flux hors - Δθ, est caractérisée par la même longueur d'onde λ que P'. Par conséquent, P' et P" sont susceptibles d'interférer. Selon la variante de la figure 13, à l'aide d'un miroir M, on fait se croiser les ondes P' et P" de telle façon qu'elles créent, dans une zone de l'espace, un réseau de franges d'interférence, c'est-à-dire une modulation périodique d'intensité lumineuse. Dans la zone d'interférence, on place un hologramme épais H' dans lequel a été inscrit une modulation périodique de son indice de réfraction de même période que les franges mais déphasée de π/2 par rapport aux franges. On peut alors observer l'addition des flux de P' et P" dans la direction de P'. Le faisceau P"' résultant présente les mêmes caractéristiques géométriques que P' (front de phase et Δθ) mais une intensité amplifiée par rapport à P' (aux dépens de l'intensité de P"). Cette variante permet ainsi d'accroître le flux lumineux selon P"' dans la bande passante Δθ.

Le déphasage de π/2 nécessaire à ce transfert peut être obtenu par translation de l'hologramme H' par rapport aux franges d'interférence.

Au lieu de l'hologramme préenregistré, on peut utiliser un cristal photoréfractif suivant la technique du mélange à deux ondes. Dans ces conditions, les franges d'interférence de P' et P", localisées dans le cristal, créent la modulation d'indice qui se déphasent automatiquement de π/2 par rapport aux franges sous l'effet de champs électriques internes au cristal.

Le matériau utilisé pour le dispositif H' de la figure 13 peut être de même type que celui utilisé pour le dispositif H des figures 6a, 6b dans le cas d'un hologramme préenregistré.

Dans le cas d'un dispositif de type mélange à deux ondes on peut utiliser des cristaux photoréfractifs tels que BaTiO$_3$ ou CdTeV.

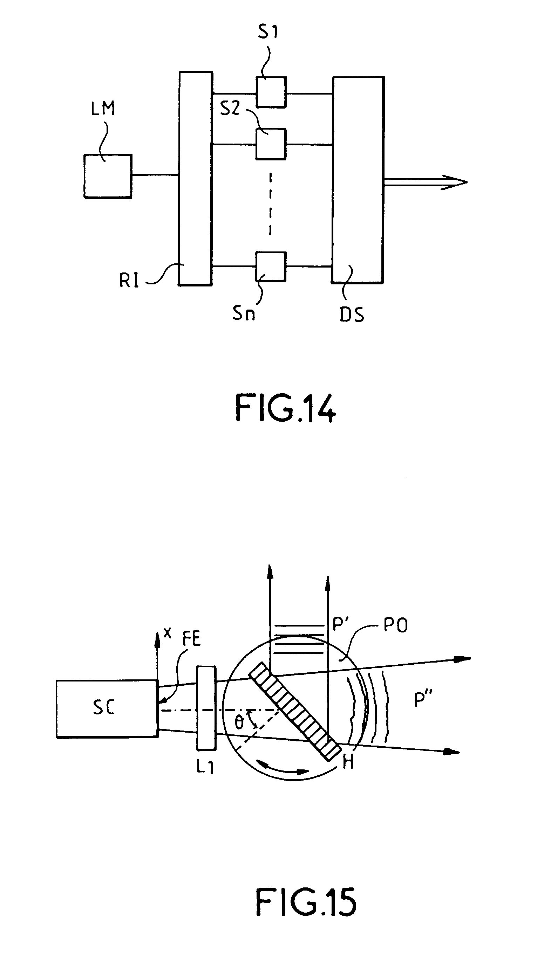

La figure 14 représente une variante de réalisation dans laquelle la source SC est réalisée à l'aide de plusieurs sources S1, S2, ... Sn (lasers esclaves) pompées par une source laser maître LM. Un séparateur de faisceaux RI réparti le faisceau du laser maître vers les différents lasers esclaves. Les faisceaux émis par les lasers esclaves sont superposés dans un dispositif de superposition DS pour fournir un faisceau mono-longueur d'onde λ quasi-cohérent. C'est ce faiceau qui est transmis au dispositif holographique des figures 6a, 6b.

L'invention consiste donc en une source optique cohérente comportant un sous-ensemble émissif à semi-conducteur produisant un faisceau proche de la limite de diffraction et un ou plusieurs hologrammes du type "épais" (ou hologramme de volume) agissant comme filtre angulaire.

Quelles que soient les conditions de fonctionnement de l'émetteur à semi-conducteur, le filtre holographique limite l'étendue angulaire du flux à une bande passante correspondant à la limite de diffraction.

En outre, le filtre holographique permet de récupérer le flux émis hors bande passante et de le restituer dans la bande passante par un autre dispositif de mélange d'ondes.

L'invention présente les avantages suivants :

<u>Compacité</u>

Comme il s'agit d'un filtrage de rayons suivant leur direction de propagation et puisqu'on n'a pas besoin de prévoir de distance focale pour le dispositif holographique, celui-ci peut être en contact de la lentille $L_1$ (sur les figures 6a, 6b).

<u>Facilité de réalisation et faible coût</u> de ce système : la fabrication de l'hologramme s'apparente à une exposition photographique.

<u>Tolérance au positionnement</u> puisqu'on filtre des directions angulaires et non plus une tache étroite. Seule l'orientation du réseau d'indice par rapport au faisceau incident donc du dispositif holographique est critique. Cette rotation est aussi équivalente à un réglage du filtre angulaire par rapport à la longueur d'onde du laser SC. Il n'y a pas de renvoi de l'énergie hors-bande passante vers la source laser SC.

**Revendications**

1. Dispositif optique d'émission mono-longueur d'onde à bande passante angulaire réduite comprenant une source optique (SC) émettant un faisceau lumineux (P) mono-longueur d'onde, caractérisé en ce qu'il comporte aussi un dispositif holographique (H) dans lequel a été enregistré un réseau d'indice par interférence de deux ondes lumineuses planes d'enregistrement (P1, P2) toutes deux mono-longueur d'onde à une même valeur déterminée et dirigées selon deux directions (D1, D2) concourantes dans le dispositif holographique, ledit dispositif holographique (H) étant éclairé par ledit faisceau lumineux (P).

2. Dispositif selon la revendication 1, caractérisé en ce que la longueur d'onde dudit faisceau lumineux (P) est égale à la longueur d'onde des deux ondes d'enregistrement et en ce qu'il est incident sur le dispositif holographique (H) selon une direction (D1) correspondant à la direction de l'une des ondes d'enregistrement (P1).

3. Dispositif selon la revendication 1, caractérisé en ce que la longueur d'onde dudit faisceau lumineux (P) est différente de la longueur d'onde des deux ondes d'enregistrement, et en ce qu'il est incident sur le dispositif holographique (H) selon une direction (D'1) qui permette une diffraction maximale du faisceau selon une deuxième direction (D'2).

4. Dispositif selon l'une des revendications 1 ou 2, caractérisé en ce qu'il comporte des moyens d'orientation du dispositif holographique (H) par rapport à la direction d'incidence dudit faisceau lumineux (P) de façon à régler l'angle d'incidence de ce faisceau par rapport au dispositif holographique.

5. Dispositif selon l'une des revendications précédentes, caractérisé en ce qu'il comporte une lentille (L1) entre la source optique (SC) et le dispositif holographique (H) permettant de transmettre à celui-ci un faisceau lumineux sensiblement collimaté.

6. Dispositif selon la revendication 5, caractérisé en ce que la source (SC) comprend un laser à semi-conducteur et en ce que la lentille (L1 ) est cylindrique, son axe étant parallèle au plan de la jonction du laser (SC).

7. Dispositif selon la revendication 5, caractérisé en ce que la source laser comporte plusieurs lasers à semi-conducteur (S1, ... Sn) pompés chacun par un laser maître (LM) et émettant plusieurs faisceaux lasers en parallèle, un dispositif de superposition de faisceaux (DS) recevant ces différents faisceaux et émettant un faisceau unique.

8. Dispositif selon la revendication 5, caractérisé en ce que la lentille (L1 ) est une lentille holographique à réseau d'indice.

9. Dispositif selon la revendication 8, caractérisé en ce que la lentille holographique (L1 ) est accolée au dispositif holographique (H).

10. Dispositif selon la revendication 8, caractérisé en ce que la lentille holographique (L1) et le dispositif holographique (H) sont enregistrés dans un même dispositif holographique.

**11.** Dispositif selon la revendication 5, caractérisé en ce que la lentille (L1 ) est une lentille holographique de surface ou à reliefs.

**12.** Dispositif selon la revendication 1, caractérisé en ce que le dispositif holographique (H) transmet, selon une première direction, une première onde plane (P') dont le diagramme de rayonnement est compris dans une bande angulaire déterminée (Δθ) et, selon une deuxième direction, une deuxième onde ou plusieurs (P'') dont le diagramme de rayonnement est situé en-dehors de cette bande angulaire ; et en ce qu'il comporte également un dispositif de réflexion (M) permettant de rendre concourant la première et la deuxième ondes (P', P''), ainsi qu'un dispositif de transfert d'énergie (H') situé dans la zone d'interférence des deux ondes (P', P''), ce dispositif transférant l'énergie de la seconde onde dans la direction de la première onde sans que le diagramme de rayonnement de cette première onde ne soit modifié.

**13.** Dispositif selon la revendication 12, caractérisé en ce que le dispositif de transfert d'énergie est un cristal photoréfractif de mélange à deux ondes.

**14.** Dispositif selon la revendication 12, caractérisé en ce que le dispositif de transfert d'énergie est hologramme préenregistré à l'aide de deux ondes de même longueur d'onde que la première et la deuxième ondes, celles-ci étant dirigées dans l'hologramme préenregistré de telle façon que leurs franges d'interférence soient déphasées de $\pi/2$ par rapport aux franges du réseau d'indice inscrit dans l'hologramme.

**Patentansprüche**

**1.** Optische Vorrichtung zur Emission einer Welle mit einer Frequenz in einem engen winkelmäßigen Durchlaßband, mit einer Lichtquelle (SC), die einen Lichtstrahl (P) einer Welle mit einer Frequenz aussendet, dadurch gekennzeichnet, daß sie weiter eine holographische Vorrichtung (H) enthält, in der durch Interferenz zweier ebener Wellen (P1, P2), die beide eine einzige und gemeinsame bestimmte Frequenz besitzen und gemäß zwei konvergierenden Richtungen (D1, D2) orientiert sind, ein Refraktionsstreifennetz registriert wird, wobei die holographische Vorrichtung (H) durch den Lichtstrahl (P) beleuchtet wird.

**2.** Vorrichtung nach Anspruch 1, dadurch gekennzeichnet, daß die Wellenlänge des Lichtstrahls (P) der Wellenlänge der beiden bei der Registrierung verwendeten Wellen gleicht und daß dieser Lichtstrahl auf die holographische Vorrichtung (H) gemäß einer Richtung (D1) entsprechend der Richtung einer der bei der Registrierung verwendeten Wellen (P1) auftrifft.

**3.** Vorrichtung nach Anspruch 1, dadurch gekennzeichnet, daß die Wellenlänge des Lichtstrahls (P) sich von der Wellenlänge der beiden bei der Registrierung verwendeten Wellen unterscheidet und daß dieser Lichtstrahl auf die holographische Vorrichtung (H) gemäß einer Richtung (D'1) auftrifft, die eine maximale Beugung des Strahls gemäß einer zweiten Richtung (D'2) erlaubt.

**4.** Vorrichtung nach einem der Ansprüche 1 oder 2, dadurch gekennzeichnet, daß sie Mittel zur Ausrichtung der holographischen Vorrichtung (H) bezüglich der Einfallsrichtung des Lichtstrahls (P) besitzt, sodaß der Auftreffwinkel dieses Strahls auf die holographische Vorrichtung justiert werden kann.

**5.** Vorrichtung nach einem der vorstehenden Ansprüche, dadurch gekennzeichnet, daß sie eine Linse (L1) zwischen der Lichtquelle (SC) und der holographischen Vorrichtung (H) besitzt, mit der der Lichtstrahl im wesentlichen kollimatiert an die Vorrichtung übertragen werden kann.

**6.** Vorrichtung nach Anspruch 5, dadurch gekennzeichnet, daß die Quelle (SC) einen Halbleiterlaser enthält und daß die Linse (L1) zylindrisch ist und ihre Achse parallel zur Ebene des Halbleiterübergangs des Lasers (SC) verläuft.

**7.** Vorrichtung nach Anspruch 5, dadurch gekennzeichnet, daß die Laserquelle mehrere Halbleiterlaser (S1, ..., Sn) enthält, die alle von einem Meisterlaser (LM) gepumpt werden und mehrere Laserstrahlen parallel aussenden, und daß eine Überlagerungsvorrichtung (DS) diese verschiedenen Strahlen empfängt und einen gemeinsamen Strahl aussendet.

**8.** Vorrichtung nach Anspruch 5, dadurch gekennzeichnet, daß die Linse (L1) eine holographische Linse mit einem Diffraktionsstreifennetz ist.

**9.** Vorrichtung nach Anspruch 8, dadurch gekennzeichnet, daß die holographische Linse (L1) an der holographischen Vorrichtung (H) anliegt.

**10.** Vorrichtung nach Anspruch 8, dadurch gekennzeichnet, daß die holographische Linse (L1) und die holographische Vorrichtung (H) in einer gemeinsamen holographischen Vorrichtung registriert sind.

**11.** Vorrichtung nach Anspruch 5, dadurch gekennzeichnet, daß die Linse (L1) eine flächenholographische oder reliefholographische Linse ist.

**12.** Vorrichtung nach Anspruch 1, dadurch gekennzeichnet, daß die holographische Vorrichtung (H) gemäß einer ersten Richtung eine erste ebene Welle (P'), deren Strahlungsdiagramm in einem bestimmten winkelmäßigen Band ($\Delta\theta$) enthalten ist, und gemäß einer zweiten Richtung eine zweite oder mehrere zweite Wellen (P'') überträgt, deren Strahlungsdiagramm außerhalb des winkelmäßigen Bands liegt, und daß die Vorrichtung weiter eine Reflexionsvorrichtung (M) enthält, die es erlaubt, die erste und die zweiten Wellen (P', P'') zusammenzuführen, sowie eine Energietransfervorrichtung (H') in der Interferenzzone der beiden Wellen (P', P''), wobei diese Vorrichtung Energie der zweiten Wellen in die Richtung der ersten Welle transferiert, ohne daß das Strahlungsdiagramm der ersten Welle dadurch verändert würde.

**13.** Vorrichtung nach Anspruch 12, dadurch gekennzeichnet, daß die Energietransfervorrichtung ein photorefraktiver Kristall ist und zwei Wellen mischt.

**14.** Vorrichtung nach Anspruch 12, dadurch gekennzeichnet, daß die Energietransfervorrichtung ein vorher mithilfe zweier Wellen gleicher Wellenlänge wie die erste und die zweite Welle registriertes Hologramm ist, wobei diese Wellen im vorher registrierten Hologramm so ausgerichtet sind, daß ihre Interferenzstreifen um $\pi/2$ in der Phase bezüglich der Streifen des Refraktionsstreifennetzes verschoben sind, das im Hologramm registriert ist.

**Claims**

**1.** Single-wavelength emission optical device with small angular passband, comprising an optical source (SC) emitting a single-wavelength light beam (P) characterized in that it also comprises a holographic device (H) in which an index grating has been recorded by the interference of two plane recording light waves (P1, P2), having a single wavelength with one and the same determined value and being directed in two concurrent directions (D1, D2) in the holographic device, the said holographic device (H) being illuminated by the said light beam (P).

**2.** Device according to Claim 1, characterized in that the wavelength of the said light beam (P) is equal to the wavelength of the two recording waves and in that it is incident on the holographic device (H) in a direction (D1) corresponding to the direction of one of the recording waves (P1).

**3.** Device according to Claim 1, characterized in that the wavelength of the said light beam (P) is different from the wavelength of the two recording waves, and in that it is incident on the holographic device (H) in a direction (D'1) that permits maximum diffraction of the beam in a second direction (D'2).

**4.** Device according to one of Claims 1 and 2, characterized in that it includes means for orientating the holographic device (H) with respect to the direction of incidence of the said light beam (P) so as to set the angle of incidence of this beam with respect to the holographic device.

**5.** Device according to one of the preceding claims, characterized in that it includes a lens (L1) between the optical source (SC) and the holographic device (H), allowing a substantially collimated light beam to be transmitted to the latter.

**6.** Device according to Claim 5, characterized in that the source (SC) comprises a semiconductor laser and in that the lens (L1) is cylindrical, its axis being parallel to the plane of the junction of the laser (SC).

**7.** Device according to Claim 5, characterized in that the laser source includes a plurality of semiconductor lasers (S1, ....Sn), each pumped by a master laser (LM) and emitting a plurality of laser beams in parallel, a beam superposition device (DS) receiving these various beams and emitting a single beam.

**8.** Device according to Claim 5, characterized in that the lens (L1) is a holographic lens with an index grating.

**9.** Device according to Claim 8, characterized in that the holographic lens (L1) is attached to the holographic device (H).

**10.** Device according to Claim 8, characterized in that the holographic lens (L1) and the holographic device (H) are recorded in one and the same holographic device.

**11.** Device according to Claim 5, characterized in that the lens (L1) is a surface holographic lens or a relief holographic lens.

**12.** Device according to Claim 1, characterized in that the holographic device (H) transmits, in a first direction, a first plane wave (P) whose radiation diagram is contained in a determined angular band ($\Delta\theta$) and, in a second direction, a second wave or a plurality thereof (P''), whose radiation diagram lies outside this angular band, and in that it also includes a reflection device (M) allowing the first and second waves (P',P'') to be made concurrent, as well as an energy transfer device (H') located in the zone of interference of the two waves (P',P''), this device transferring the energy of the second wave in the direction of the first wave without any modification of the radiation diagram of this first wave.

13. Device according to Claim 12, characterized in that the energy transfer device is a two-wave mixing photorefractive crystal.

14. Device according to Claim 12, characterized in that the energy transfer device is a hologram pre-recorded by means of two waves having the same wavelength as the first and second waves, the latter being directed in the pre-recorded hologram in such a way that their interference fringes are phase-shifted by $\pi/2$ with respect to the fringes of the index grating inscribed in the hologram.

FIG.1

FIG.2

FIG.3a

FIG.3b

Lobe
principal

↑ Intensité

Δθ

θ

"Pieds"

## FIG.4

x

Δθ1

SC

FE

L₁

f1

DP

F'₁

F2

d

f2

L2

Δθ2

z

## FIG.5a

y FE

z

## FIG.5b

FIG.6a

FIG.6b

Franges d'interférence
--> réseau d'indice de réfraction

FIG.7

FIG.8a

FIG.8b

FIG.9

**FIG.10a**

Franges d'interférence
réseau d'indice de réfraction

**FIG.10b**

SC     L1     H

Onde limitée par
P'       Δθ

# FIG.11

H
L1

Hologramme épais
filtre angulaire

SC

Hologramme de
surface lentille

# FIG.12

P'''

H'

P'

M

P''

SC

# FIG.13

EP 0 708 509 B1

FIG.14

FIG.15

16